# EUROPEAN PATENT SPECIFICATION

(11) **EP 4 125 124 B1**
(45) Date of publication and mention of the grant of the patent: **18.11.2026**
(21) Application number: 22187310.2
(22) Date of filing: 27.07.2022
(51) Int. Cl.: H10W 70/40, H10W 90/00

(54) **METHOD OF MANUFACTURING SUBSTRATES FOR SEMICONDUCTOR DEVICES, CORRESPONDING SUBSTRATE AND SEMICONDUCTOR DEVICE**
VERFAHREN ZUR HERSTELLUNG VON SUBSTRATEN FÜR HALBLEITERBAUELEMENTE, ENTSPRECHENDES SUBSTRAT UND HALBLEITERBAUELEMENT
PROCÉDÉ DE FABRICATION DE SUBSTRATS POUR DISPOSITIFS À SEMICONDUCTEUR, SUBSTRAT CORRESPONDANT ET DISPOSITIF À SEMICONDUCTEUR

(30) Priority: 28.07.2021 IT 202100020111
(43) Date of publication of application: 01.02.2023
(73) Proprietor: STMicroelectronics S.r.l., 20864 Agrate Brianza (MB) (IT)
(72) Inventor: MAZZOLA, Mauro, I-24040 Calvenzano (Bergamo) (IT)
(74) Representative: Buzzi, Notaro & Antonielli d'Oulx S.p.A.

(56) References cited:
- US-A- 5 532 905
- US-A1- 2005 199 986
- US-A1- 2009 250 795
- US-A1- 2011 115 061
- US-A1- 2013 009 299

## Description

### Technical field

The description relates to semiconductor devices.

One or more embodiments can be applied to semiconductor power devices for the automotive sector, for instance.

### Background

In substrates such as pre-molded leadframes, adequate adhesion between the sculptured, electrically conductive structure of the leadframe (copper, for instance) and the pre-mold resin (an epoxy resin, for instance) molded thereon should desirably absorb stresses generated if the pre-molded leadframe is pressed or bent, thus countering the formation of cracks which may also propagate along the leadframe.

It is noted that stress, and thus the risk of cracks being generated, increases in the case of narrow strips of pre-mold material.

Document US 2011/115061 A1 discloses an electronic device including a packaging material having a first surface and a second surface opposite the first surface, and leads including die connection surfaces and external connection surfaces. The electronic device further includes a trench extending from an upper surface of the packaging substrate towards a lower surface of the packaging substrate, wherein a set of leads lie immediately adjacent to the trench, and the packaging material is exposed at the bottom of the trench. An encapsulant is formed over the upper surface of the packaging substrate and within the trench. The trenches may be formed before or after placing a die over the packaging substrate, or before or after forming electrical connections between the die and leads of the packaging substrate.

Document US 2013/009299 A1 discloses a semiconductor device inhibited from being degraded in reliability with tab including a top surface, a bottom surface, and a plurality of side surfaces. Each of the side surfaces of the tab has a first portion continued to the bottom surface of the tab, a second portion located outwardly of the first portion and continued to the top surface of the tab, and a third portion located outwardly of the second portion and continued to the top surface of the tab to face the same direction as each of the first and second portions. In planar view, the outer edge of the semiconductor chip is located between the third portion and the second portion of the tab, and the outer edge of an adhesive material fixing the semiconductor chip to the tab is located between the semiconductor chip and the second portion.

Document US 2009/250795 A1 discloses a packaged electronic device including a die pad, leads arranged around the die pad, and a die attached to an upper surface of the die pad and electrically connected to the leads. A packaging material encapsulates the die pad, the die, and the leads. The die pad includes indentations formed in the upper surface along a sidewall of the die pad as well as indentations formed in a lower surface of the die pad along the sidewall. The packaging material fills the indentations thereby promoting adhesion between the die pad and the packaging material so that the die pad and packaging material (28) cannot readily delaminate.

Document US 2005/199986 A1 discloses a leadframe includes a die pad, a plurality of tie bars, a plurality of metal extrusions and a plurality of leads. The leads are arranged around the die pad. The tie bars are connected to the corners of the die pad, and the metal extrusions are connected to the sides of the die pad but separated from the tie bars. Each metal extrusion has a locking hole and a bonding surface, which is higher than the die pad. The metal extrusions are configured for improving ground connections by wire-bonding. When a bottom surface of the die pad is exposed from an encapsulant for a semiconductor package, the metal extrusions help to secure the die pad without stress transmission.

### Object and summary

An object of one or more embodiments is to deal with the issues as discussed in the foregoing.

According to one or more embodiments, that object can be achieved thanks to a method having the features set forth in claim 1 that follows.

One or more embodiments relate to a corresponding substrate (leadframe) for semiconductor devices as per claim 8.

One or more embodiments relate to a semiconductor device as per claim 12.

The claims are an integral part of the technical teaching provided herein with reference to the embodiments.

One or more embodiments rely on a modification of die pad shape, optionally at the front or top side only, of a substrate such as a leadframe.

In certain examples, a lateral half-etched stress-relief (or stress-reducing) protrusion is created in a die pad leaving the bottom side of the die pad straight.

Such a shape facilitates absorbing stresses that are generated in response to the substrate (leadframe) being bent or possibly pressed during wire bonding, for instance.

One or more embodiments facilitate producing smaller semiconductor device packages.

### Brief description of the annexed figures

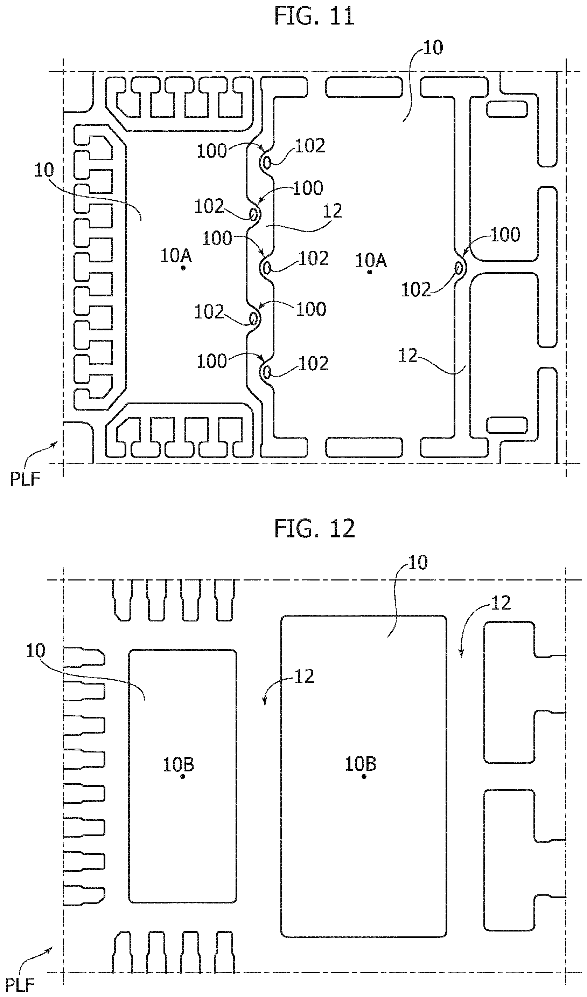

One or more embodiments will now be described, by way of example only, with reference to the annexed figures. It is noted that, while the other figures are useful in understanding the invention, the invention as claimed in claim 1 is expressly visible only in Figure 11. In the Figures:
Figure 1 is exemplary of the possible formation of cracks in a substrate such as a pre-molded leadframe,
Figure 2 is a plan view of a pre-molded leadframe highlighting areas more exposed to the formation of cracks,
Figure 3 is exemplary of measures that can be attempted in order to counter the formation of cracks in pre-molded leadframes,
Figures 4A and 4B are plan views of pre-molded leadframes illustrative of possible topologies exposed to the formation of cracks,
Figures 5A and 5B are illustrative of a pre-molded leadframe,
Figure 6 is a view of the portion of Figure 5A indicated by arrow VI reproduced on an enlarged scale,
Figures 7 and 8 are cross-sectional views along lines VII-VII and line VIII-VIII in Figure 6, respectively, reproduced on a further enlarged scale,
Figure 9 is a view of a portion of leadframe like the portion illustrated in Figure 6, showing possible advantageous features of embodiments,
Figure 10 is a cross-sectional view along line X-X of Figure 9 reproduced on a further enlarged scale, and
Figures 11 and 12 are plan views of a pre-molded leadframe according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments.

The headings/references used herein are provided merely for convenience and hence do not define the extent of protection or the scope of the embodiments.

Semiconductor devices may comprise one or more semiconductor chips or dice arranged (attached) on substrates such as leadframes.

Plastic packages are commonly used for semiconductor devices. Such packages may include a leadframe providing a base substrate comprising electrically conductive material such as copper, sized and shaped to accommodate semiconductor chips or dice and providing pad connections (leads) for these chips or dice.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Leadframes are conventionally created using technologies such as a photo-etching technology. With this technology, metal (e.g., copper) material in the form of a foil or tape is etched on the top and bottom sides to create various pads and leads.

Substrates such as leadframes are advantageously provided in a pre-molded version wherein an insulating resin (an epoxy resin, for instance) fills the empty spaces between the die pads and leads.

A pre-molded leadframe is a thus a laminar substrate that is substantially flat with the pre-mold material (resin) filling the spaces in the electrically conductive structure (of metal material such as copper, for instance) of the leadframe, that has been bestowed a sculptured appearance including empty spaces during forming, by etching, for instance.

The total thickness of the pre-mold leadframe is the same thickness of the sculptured electrically conductive structure.

During the assembly process of semiconductor devices using pre-molded leadframe, a pre-molded leadframe can be exposed to repeated stress.

For instance, during handling or when deposited in a slot magazine the leadframe could be bent merely due to its weight.

Also, during wire bonding, the leadframe is subject to clamping and the bonding tools that place the bonding wires or ribbons may further stress the leadframe structure.

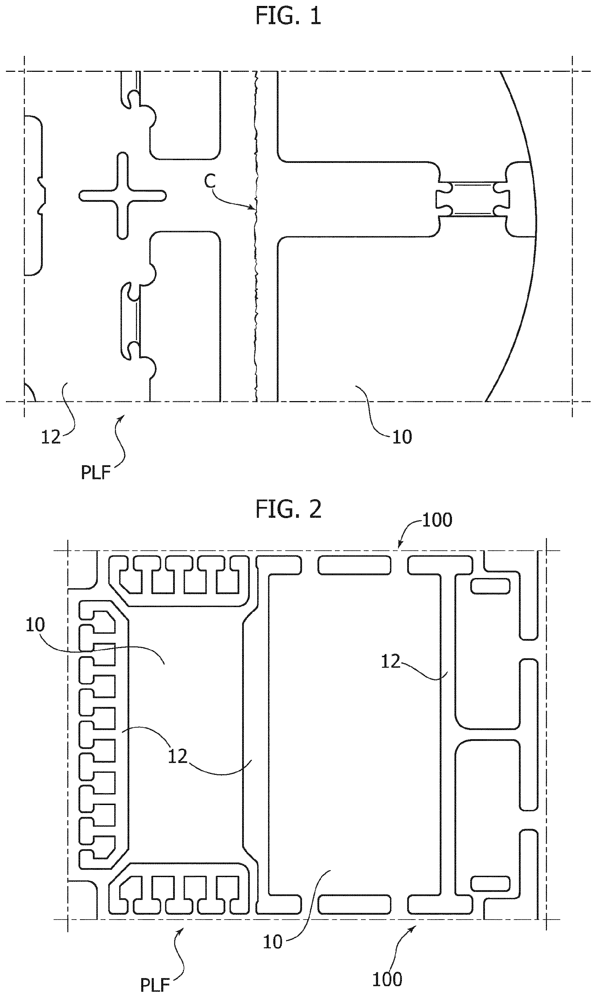

Figure 1 is exemplary of a crack C possibly formed in a pre-molded leadframe illustrated as comprising, in general, electrically conductive (metal, e.g., copper) portions 10 included in a sculptured, electrically conductive structure of the leadframe, having spaces filled by the pre-mold material (resin) 12.

For instance, as depicted in Figure 1, in response to the pre-mold leadframe being bent, a crack C can be formed in the resin 12 with the crack likely to propagate along an elongated portion of the pre-mold material 12.

The presence of such cracks is a source of material rejection.

The plan view of Figure 2 shows that the formation and propagation of cracks may be related to the fact that in certain pre-molded leadframe topologies, two sides connected by connecting bars 100 may represent the sole portions of the leadframe resisting flexural stresses.

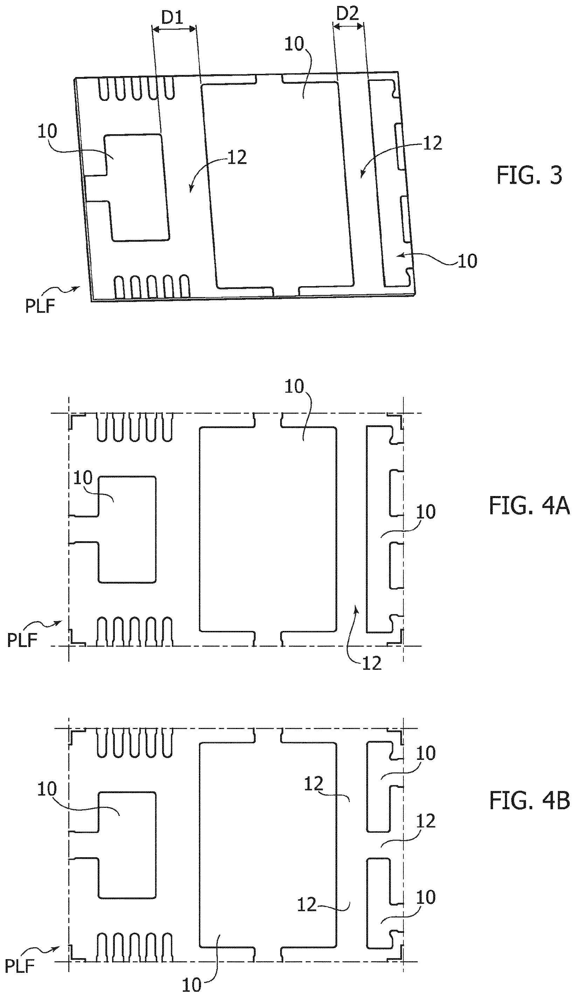

Figure 3 is exemplary of the trend towards an increasingly high number of devices being hosted onto a leadframe PLF in order to decrease the cost of the associated units while reducing the package size.

Reducing package size may involve reducing the spacing between adjacent conductive portions of the pre-molded leadframes such as die pads 10. This in turn translates into reducing the width (see, for instance, D1 and D2 in Figure 3) of the portions of pre-mold material 12 included therebetween.

The pre-mold material 12 between adjacent die pads 10 may thus be reduced to very narrow straight lines. Reducing widths such as D1 and D2 makes the pre-mold material (resin) more fragile.

The pre-mold material 12 is thus more easily exposed to the formation of cracks if the leadframe PLF is bent, pressed or pulled, with the risk that such cracks can easily expand (propagate) over the whole surface of the leadframe.

Figures 4A and 4B facilitate understanding that the risk of formation and propagation of cracks may exist both in rectilinear areas of the pre-mold material (such as the one indicated at 12 in Figure 4A, which refers to a single-channel power Quad-Flat No-leads or QFN package) and, even more, in those areas where of the pre-mold material 12 exhibits more complex shapes such as a T-shape as indicated by plural references 12 in Figure 4B (which refers to a dual-channel power QFN package)

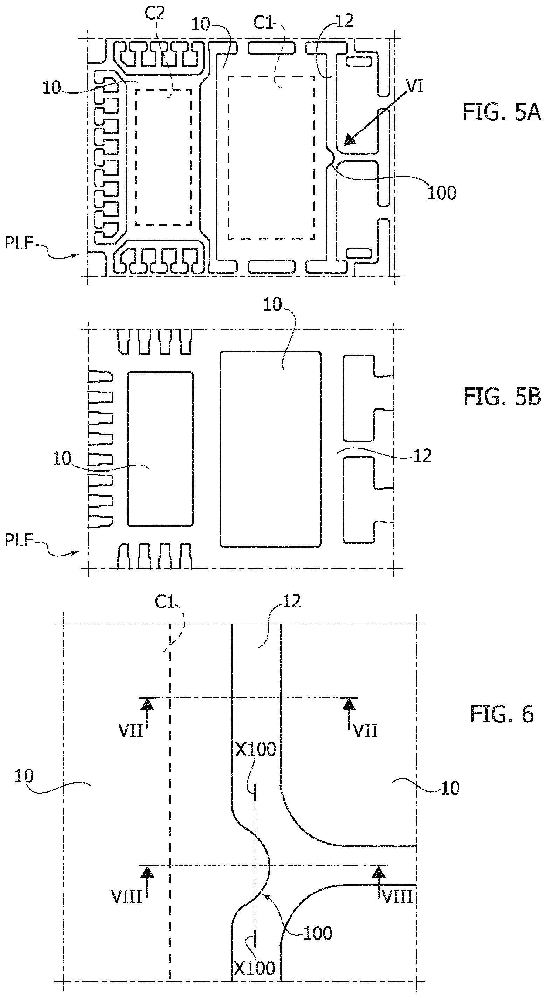

Figures 5A and 5B are plan views of a pre-molded leadframe PLF.

Figure 5A reproduces the level of the front or top surface of the leadframe PLF, where one or more semiconductor chips or dice C1, C2 (shown in dashed outline) are intended to be mounted at the front or top surfaces of respective die pads 10.

Figure 5B is a plan views of the same pre-molded leadframe PLF at the level of the back or bottom surface, where the die pads 10 may be exposed, that is left uncovered by the pre-mold material 12 (this may facilitate, for instance, dissipation of the heat generated by the chips C1, C2 during operation).

It is noted that Figures 5A and 5B refer to a leadframe topology as exemplified in Figure 4B (dual channel pads intended to be coupled with respective ribbons, not visible in the figures) which is regarded as particularly critical insofar as the formation of cracks is concerned.

It will be otherwise appreciated that Figures 5A and 5B (and the subsequent figures as well) are exemplary of pre-molded leadframes including, as otherwise conventional in the art, a sculptured, electrically conductive laminar structure having (originally empty) spaces therein and a pre-mold material (such as a resin 12) molded onto the laminar structure and filling those spaces.

The pre-mold material penetrates into the spaces in the sculptured, electrically conductive structure to provide, once solidified (via UV or heat curing, for instance) a laminar pre-molded substrate PLF.

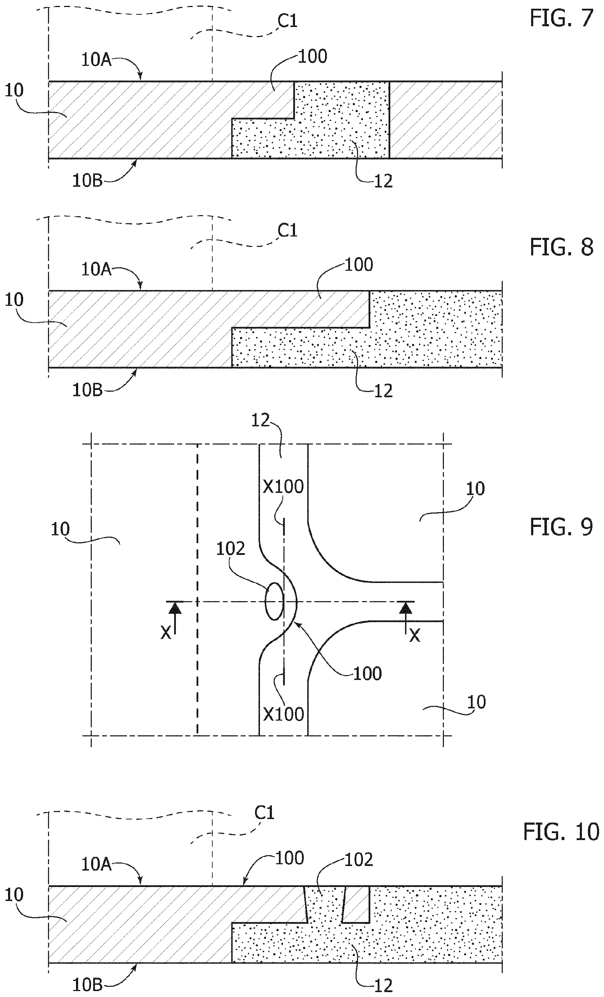

As illustrated, such a sculptured, electrically conductive laminar structure comprises, in addition to other features that will not be discussed here for simplicity, one or more die pads 10 having (see primarily Figures 7, 8 and 10):
a first, front or top, die pad surface 10A intended to be left exposed, that is uncovered, by the pre-mold material 12 to facilitate mounting one or more semiconductor chips or dice C1, C2 thereon, and
a second, back or bottom surface 10B, opposite the front or top surface 10A, where the die pads 10 may be left likewise exposed, that is uncovered, by the pre-mold material 12.

As used therein, "may" highlights the fact that, in certain embodiments, one or more of the die pads 10 may be die pads having a thickness that is less (half, for instance, hence the current "half-etched" definition) than the overall thickness of the pre-molded leadframe.

In that way, the "half-etched" die pad or pads will be covered at their back surfaces 10B by the (electrically insulating) pre-mold material 12 giving rise to insulated die pads.

Whatever the details of implementation, in pre-mold leadframes PLF as exemplified herein, the die pads 10 have their periphery (that is, the sides) bordering on (a strip of) the pre-mold material 12 molded onto the laminar structure of the leadframe.

In conventional solutions as exemplified in Figures 1 to 4B, the die pads 10 are rectangular pads that border on the pre-mold material 12 along rectilinear border lines throughout (with slightly rounded tip portions, at most) .

Even without wishing to be bound to any specific theory in that respect, these rectilinear borderlines are found to be at the basis of the formation (and propagation) of cracks such as the crack C illustrated in Figure 1.

Examples as presented in Figures 5A onwards, contemplate providing at the periphery of one or more die pads, optionally (only) at the first die pad surface 10A, at least one stress-relief (or stress-reducing) curved portion 100 configured to border on the pre-mold material 12 over a (lateral) rounded surface, that is over a smooth, curved surface (that is, an even and regular surface free from perceptible projections, lumps, or indentations).

As exemplified in Figure 6, the stress-relief curved portion 100 may comprise, e.g., a protrusion of the die pad 10 extending into the pre-mold material 12.

As visible, e.g., in Figure 6, the stress-relief portion 100 may exhibit, when observed in a plan view, a profile which can be regarded as a serpentine, at least approximately sinusoidal trajectory with respect to a reference median line X100 parallel to the (otherwise rectilinear) side of the die pad 10.

That is, the stress-relief curved portion 100 extends in the plane of the laminar pre-molded substrate PLF (the thickness thereof is de facto negligible) along an approximately sinusoidal trajectory.

Again, without wishing to be bound to any specific theory in that respect, such an approximately sinusoidal shape was found to be particularly effective in countering possible formation and propagation of cracks.

As appreciable in Figure 6, for instance, the stress-relief curved portion 100 is advantageously located at the same location where the pre-mold material 12 fills a T-shaped (originally) empty space in the sculptured electrically conductive structure of the leadframe.

As visible in Figure 6, in the case of stress-relief curved portion 100 formed by a protrusion of the leadframe 10, this results in turning what was a T-shaped space (see Figure 4B) intended to be filled by the pre-mold material 12 into a Y-shaped space with rounded edges.

Such a curved shape was felt to be particularly effective in absorbing stresses originating when the leadframe PLF is bent or pressed (during wire bonding, for instance).

This result was found to be particularly advantageous in those cases where the (straight) resin portion is more than 50% of the package width.

Figures 9 and 10 are exemplary of arrangements where the stress-relief curved portion 100 is a protrusion traversed by **(e.g.,** has formed therein) a through-hole 102 that (see, **e.g.,** Figure 10) is filled by the pre-mold material 12.

This arrangement was found to be particularly effective in providing a strong locking between the sculptured structure of the leadframe (die pads 10) and the pre-mold material 12 filling the spaces therein.

Advantageously, rather than a round hole, the hole 102 may be an elongated hole (a buttonhole) having a major dimension in the direction of the side of the leadframe 10.

Also, as visible in Figure 10, the hole 102 may present a slightly tapered shape starting from the front pad surface 10A. Such shape can be advantageously provided during forming the sculptured structure of the leadframe via etching.

Advantageously, as visible in figures such as Figures 8 and 10, the stress-relief curved portion 100 (a recess or, advantageously, a protrusion) can be provided only adjacent one of the opposed surfaces 10A, 10B of the die pad 10.

For instance, as illustrated herein, the stress-relief curved portion(s) 100 can be provided only at the front or top pad surface 10A, while the opposite surface (here, the back or bottom pad surface 10B opposite the front or top surface 10A) retains a generally rectilinear shape.

In certain embodiments, a complementary option can be adopted with the stress-relief curved portion(s) 100 provided only at the back or bottom pad surface 10B, while the front or top surface 10A retains a generally rectilinear shape.

In certain embodiments, the stress-relief curved portion(s) 100 can be provided over the whole thickness of the die pad, that is both at the front or top pad surface 10A and at the back or bottom pad surface 10B.

The foregoing applies irrespective of the fact that one or more holes such as 102 are provided in the stress-relief portion 100.

Figures such as Figure 7 also illustrate that, as otherwise conventional in the art, the periphery of die pads such as 10 may have a stepped profile, with the front or top surface 10A larger than (and thus protruding with respect to) the back or bottom surface 10B.

Figures 11 and 12 are further views of a pre-molded leadframe PLF at the level of the front or top surfaces 10A of die pads 10 provided therein and at the level of the back or bottom surface 10B of the die pads 10.

Figures 11 and 12 are exemplary of the possibility of providing one or more stress-relief curved portions 100 only adjacent the front die pad surface 10A while the sides of the back or bottom surfaces 10B (see Figure 12) retain a substantially rectilinear shape.

Figure 11 is also exemplary of the possibility of providing one or more stress-relief curved portion 100 (with or without holes 102) at plural locations in a leadframe.

For instance, the die pad 10 in a central position in Figure 11 has stress-relief curved portions 100 at both its major (longer) sides, which are vertical in the figure.

Also, Figure 11 is exemplary of the possibility of providing plural adjacent stress-relief curved portions 100 (again with or without holes 102) at a certain side of a leadframe.

Again, the die pad 10 in a central position in Figure 11 has a plurality of stress-relief curved portions 100 at its major (longer) side on the left and a single stress-relief curved portion 100 at its major (longer) side on the right.

For instance, in certain embodiments, a die pad 10 may have:
a single stress-relief curved portion 100 at one or more of its sides (a single portion 100 at each side),
plural stress-relief curved portions 100 at one or more of its sides (plural portions 100 at each side),
single and/or plural stress-relief curved portions 100 at all or just a part of its sides (e.g., a combination of the foregoing).

Figure 11 is also exemplary of the possibility of providing at mutually facing sides of neighbouring die pads 10 having a strip of pre-mold material 12 extending therebetween, plural stress-relief curved portions 100 at mutually facing sides of two neighbouring pads 10.

As illustrated in Figure 11, these plural stress-relief curved portions 100 in the mutually facing sides of neighboring die pads 10 can be provided as an alternation of (e.g., interdigitated) stress-relief curved portions 100 (protrusions, for instance) so that the strip of pre-mold material 12 therebetween has a general zigzag or serpentine pattern.

Arrangements as exemplified herein were found to facilitate larger adhesion surfaces to lock the pre-mold material 12 to the die pads 10, with the curvy boundary line therebetween provided by formations such as 100 being effective in absorbing stresses and countering the formation and propagation of crash therebetween.

Also, stress-relief formations 100 in the form of protrusions were found to be beneficial in facilitating a pre-mold material flow to a perpendicular channel (see, for instance, visible in Figures 6 and 9) while also facilitating (especially when holes such 102 are provided) a stronger locking of the electrically conductive and the insulating (electrically nonconductive) parts of the pre-mold leadframe.

Advantageously, in packages with the dual channel pads or channels perpendicular to a die pad (see again Figures 6 and 9: these were found to be particularly exposed to crack formation) the pre-mold material 12 does not follow a straight line and has a perpendicular portion.

The curved shape of a stress-relief formation at such a point absorbs significantly the stresses developed when the leadframe is bent or pressed (during wire bonding, for instance).

As noted, such a modification of the boundary of the die pad may occur only at one of the front surface 10A and the back surface 10B, e.g., only at the front surface 10A.

The extent of protection is determined by the annexed claims.

## Claims

1. A method, comprising:
providing a sculptured electrically conductive laminar structure (10) having spaces therein, the laminar structure including at least one die pad (10) having a first die pad surface (10A) configured to have at least one semiconductor chip (C1, C2) mounted thereon, and
molding pre-mold material (12) onto the laminar structure (10), wherein the pre-mold material (12) penetrates into said spaces and provides a laminar pre-molded substrate (PLF, 10, 12) including said first die pad surface (10A) left exposed by the pre-mold material (12) with the periphery of the at least one die pad (10) bordering on the pre-mold material (12) molded onto the laminar structure (10),
wherein the method comprises providing at the periphery of the at least one die pad (10) at least one stress-relief curved portion (100) configured to border on the pre-mold material (12) molded onto the laminar structure (10) over a smooth surface, and
the laminar structure comprises a pair of neighboring die pads (10) having a strip of pre-mold material (12) therebetween, and wherein the method comprises forming in said pair of neighboring die pads (10) an alternation of said stress-relief curved portions (100).

2. The method of claim 1, wherein the at least one stress-relief curved portion (100) extends in the plane of the laminar pre-molded substrate (PLF, 10, 12) along an approximately sinusoidal trajectory.

3. The method of claim 1 or claim 2, wherein the at least one stress-relief curved portion (100) comprises a protrusion extending into the pre-mold material (12) molded onto the laminar structure (10).

4. The method of claim 3, comprising providing in said protrusion (100) at least one aperture (102) configured to be filled by the pre-mold material (12) molded onto the laminar structure (10).

5. The method of any of claims 1 to 4, comprising providing said at least one stress-relief curved portion (100) at a location of said laminar structure (10) wherein a T-shaped space is provided for filling by the pre-mold material (12) molded onto the laminar structure (10).

6. The method of claim 1, comprising forming in said pair of neighboring die pads (10) interdigitated stress-relief curved protrusions (100) wherein said strip of pre-mold material (12) therebetween has a serpentine pattern.

7. The method of any of the previous claims, wherein the at least one die pad (10) has a second die pad surface (10B) opposite said first die pad surface (10A) and wherein the method comprises providing the at least one stress-relief curved portion (100) at one (10A) of the first die pad surface (10A) and the second die pad surface (10B) wherein, opposite said at least one stress-relief curved portion (100), the periphery of the other (10B) of the first die pad surface (10A) and the second die pad surface (10B) is rectilinear.

8. A substrate (PLF), comprising:
a sculptured electrically conductive laminar structure (10) having spaces therein, the laminar structure including at least one die pad (10) having a first die pad surface (10A) configured to have at least one semiconductor chip (C1, C2) mounted thereon,
pre-mold material (12) molded onto the laminar structure (10), wherein the pre-mold material (12) penetrates into said spaces and provides a laminar pre-molded substrate (PLF, 10, 12) including said first die pad surface (10A) left exposed by the pre-mold material (12) with the periphery of the at least one die pad (10) bordering on the pre-mold material (12) molded onto the laminar structure (10), and
at least one stress-relief curved portion (100) provided at the periphery of the at least one die pad (10), wherein the at least one stress-relief curved portion (100) borders on the pre-mold material (12) molded onto the laminar structure (10) over a smooth surface, the at least one stress-relief curved portion (100) preferably extending in the plane of the laminar pre-molded substrate (PLF, 10, 12) along an approximately sinusoidal trajectory,
wherein the laminar structure comprises a pair of neighboring die pads (10) having a strip of pre-mold material (12) therebetween, and wherein the substrate comprises, in said pair of neighboring die pads (10), an alternation of said stress-relief curved portions (100), preferably interdigitated stress-relief curved protrusions (100) wherein said strip of pre-mold material (12) therebetween has a serpentine pattern.

9. The substrate (PLF) of claim 8, wherein the at least one stress-relief curved portion (100) comprises a protrusion extending into the pre-mold material (12) molded onto the laminar structure (10), the protrusion preferably having at least one aperture (102) therein, the at least one aperture (102) filled by the pre-mold material (12) molded onto the laminar structure (10).

10. The substrate (PLF) of claim 8 or claim 9, comprising at least one stress-relief curved portion (100) of the at least one die pad (10) at a location of said laminar structure (10) wherein a T-shaped space is provided filled by the pre-mold material (12) molded onto the laminar structure (10).

11. The substrate (PLF) of any of claims 8 to 10, wherein the at least one die pad (10) has a second die pad surface (10B) opposite said first die pad surface (10A), wherein the at least one stress-relief curved portion (100) is provided at one (10A) of the first die pad surface (10A) and the second die pad surface (10B) wherein, opposite said at least one stress-relief curved portion (100), the periphery of the other (10B) of the first die pad surface (10A) and the second die pad surface (10B) is rectilinear.

12. A semiconductor device, comprising:
a substrate (PLF) according to any of claims 8 to 11, and
at least one semiconductor chip (C1, C2) mounted on said first die pad surface (10A) configured to have at least one semiconductor chip (C1, C2) mounted thereon.

## Patentansprüche

1. Verfahren, umfassend:
Bereitstellen einer skulptierten, elektrisch leitfähigen Laminarstruktur (10) mit darin vorhandenen Zwischenräumen, wobei die Laminarstruktur mindestens ein Die-Pad (10) einschließt, die eine erste Die-Pad-Oberfläche (10A) aufweist, die so konfiguriert ist, dass mindestens ein Halbleiterchip (C1, C2) darauf montiert werden kann, und
Formen von Vorformmaterial (12) auf die Laminarstruktur (10), wobei das Vorformmaterial (12) in die Zwischenräume eindringt und ein vorgeformtes Laminarsubstrat (PLF, 10, 12) bereitstellt, das das erste Die-Pad (10A) einschließt, das durch das Vorformmaterial (12) freigelegt bleibt, wobei der Umfang des mindestens einen Die-Pads (10) an das auf die Laminarstruktur (10) aufgeformte Vorformmaterial (12) angrenzt,
wobei das Verfahren das Bereitstellen mindestens eines spannungsentlastenden gekrümmten Abschnitts (100), der so konfiguriert ist, dass er an das auf die Laminarstruktur (10) aufgeformte Vorformmaterial (12) über eine glatte Oberfläche angrenzt, am Umfang des mindestens einen Die-Pads (10) umfasst, und
die Laminarstruktur ein Paar benachbarter Die-Pads (10) umfasst, die einen Streifen aus Vorformmaterial (12) zwischen sich aufweisen, und wobei das Verfahren das Bilden eines Wechsels der spannungsentlastenden gekrümmten Abschnitte (100) in dem Paar benachbarter Die-Pads (10) umfasst.

2. Verfahren nach Anspruch 1, wobei sich der mindestens eine spannungsentlastende gekrümmte Abschnitt (100) in der Ebene des vorgeformten Laminarsubstrats (PLF, 10, 12) entlang einer etwa sinusförmigen Bahn erstreckt.

3. Verfahren nach Anspruch 1 oder 2, wobei der mindestens eine spannungsentlastende gekrümmte Abschnitt (100) einen Vorsprung umfasst, der sich in das auf die Laminarstruktur (10) aufgeformte Vorformmaterial (12) erstreckt.

4. Verfahren nach Anspruch 3, umfassend das Bereitstellen mindestens einer Öffnung (102) in dem Vorsprung (100), die so konfiguriert ist, dass sie durch das auf die Laminarstruktur (10) aufgeformte Vorformmaterial (12) gefüllt wird.

5. Verfahren nach einem der Ansprüche 1 bis 4, umfassend das Bereitstellen des mindestens einen spannungsentlastenden gekrümmten Abschnitts (100) an einer Stelle der Laminarstruktur (10), wobei ein T-förmiger Zwischenraum zur Füllung durch das auf die Laminarstruktur (10) aufgeformte Vorformmaterial (12) vorgesehen ist.

6. Verfahren nach Anspruch 1, umfassend das Formen ineinandergreifender, spannungsentlastender gekrümmter Vorsprünge (100) in dem Paar benachbarter Die-Pads (10), wobei der Streifen aus Vorformmaterial (12) dazwischen ein Serpentinenmuster aufweist.

7. Verfahren nach einem der vorhergehenden Ansprüche, wobei das mindestens eine Die-Pad (10) eine zweite Die-Pad-Oberfläche (10B) gegenüber der ersten Die-Pad-Oberfläche (10A) aufweist, und wobei das Verfahren das Bereitstellen des mindestens einen spannungsentlastenden gekrümmten Abschnitts (100) an einer (10A) der ersten Die-Pad-Oberfläche (10A) und der zweiten Die-Pad-Oberfläche (10B) umfasst, wobei gegenüber dem mindestens einen spannungsentlastenden gekrümmten Abschnitt (100) der Umfang der anderen (10B) der ersten Die-Pad-Oberfläche (10A) und der zweiten Die-Pad-Oberfläche (10B) geradlinig ist.

8. Substrat (PLF), umfassend:
eine skulptierte, elektrisch leitfähige Laminarstruktur (10) mit darin vorhandenen Zwischenräumen, wobei die Laminarstruktur mindestens ein Die-Pad (10) einschließt, die eine erste Die-Pad-Oberfläche (10A) aufweist, die so konfiguriert ist, dass mindestens ein Halbleiterchip (C1, C2) darauf montiert werden kann,
Vorformmaterial (12), das auf die Laminarstruktur (10) aufgeformt ist, wobei das Vorformmaterial (12) in die Zwischenräume eindringt und ein vorgeformtes Laminarsubstrat (PLF, 10, 12) bereitstellt, das das erste Die-Pad (10A) einschließt, das durch das Vorformmaterial (12) freigelegt bleibt, wobei der Umfang des mindestens einen Die-Pads (10) an das auf die Laminarstruktur (10) aufgeformte Vorformmaterial (12) angrenzt, und
mindestens einen spannungsentlastenden gekrümmten Abschnitt (100), der am Umfang des mindestens einen Die-Pads (10) vorgesehen ist, wobei der mindestens eine spannungsentlastende gekrümmte Abschnitt (100) über eine glatte Oberfläche an das auf die Laminarstruktur (10) aufgeformten Vorformmaterial (12) angrenzt, wobei sich der mindestens eine spannungsentlastende gekrümmte Abschnitt (100) vorzugsweise in der Ebene des vorgeformten Laminarsubstrats (PLF, 10, 12) entlang einer etwa sinusförmigen Bahn erstreckt,
wobei die Laminarstruktur ein Paar benachbarter Die-Pads (10) umfasst, die einen Streifen aus Vorformmaterial (12) zwischen sich aufweisen, und wobei das Substrat in dem Paar benachbarter Die-Pads (10) einen Wechsel der spannungsentlastenden gekrümmten Abschnitte (100), vorzugsweise ineinandergreifender, gekrümmter spannungsentlastender Vorsprünge (100), umfasst, wobei der Streifen aus Vorformmaterial (12) dazwischen ein Serpentinenmuster aufweist.

9. Substrat (PLF) nach Anspruch 8, wobei der mindestens eine spannungsentlastende gekrümmte Abschnitt (100) einen Vorsprung umfasst, der sich in das auf die Laminarstruktur (10) aufgeformte Vorformmaterial (12) erstreckt, wobei der Vorsprung vorzugsweise mindestens eine Öffnung (102) darin aufweist, wobei die mindestens eine Öffnung (102) durch das auf die Laminarstruktur (10) aufgeformte Vorformmaterial (12) gefüllt ist.

10. Substrat (PLF) nach Anspruch 8 oder Anspruch 9, umfassend mindestens einen spannungsentlastenden gekrümmten Abschnitt (100) des mindestens einen Die-Pads (10) an einer Stelle der Laminarstruktur (10), wobei ein T-förmiger Zwischenraum bereitgestellt ist, der durch das auf die Laminarstruktur (10) aufgeformte Vorformmaterial (12) gefüllt ist.

11. Substrat (PLF) nach einem der Ansprüche 8 bis 10, wobei das mindestens eine Die-Pad (10) eine zweite Die-Pad-Oberfläche (10B) gegenüber der ersten Die-Pad-Oberfläche (10A) aufweist, wobei der mindestens eine spannungsentlastende gekrümmte Abschnitt (100) an einer (10A) der ersten Die-Pad-Oberfläche (10A) und der zweiten Die-Pad-Oberfläche (10B) vorgesehen ist, wobei gegenüber dem mindestens einen spannungsentlastenden gekrümmten Abschnitt (100) der Umfang der anderen (10B) der ersten Die-Pad-Oberfläche (10A) und der zweiten Die-Pad-Oberfläche (10B) geradlinig ist.

12. Halbleitervorrichtung, die Folgendes umfasst:
ein Substrat (PLF) nach einem der Ansprüche 8 bis 11, und mindestens einen Halbleiterchip (C1, C2), der auf die erste Die-Pad-Oberfläche (10A) montiert ist, die so konfiguriert ist, dass mindestens ein Halbleiterchip (C1, C2) darauf montiert werden kann.

## Revendications

1. Procédé, comprenant :
la production d'une structure laminaire électriquement conductrice sculptée (10) comportant des espaces en son sein, la structure laminaire incluant au moins un plot pour puce (10) présentant une première surface de plot pour puce (10A) configurée pour avoir au moins une puce de semi-conducteur (C1, C2) montée dessus, et
le moulage d'un matériau de prémoulage (12) sur la structure laminaire (10), le matériau de prémoulage (12) pénétrant dans lesdits espaces et produisant un substrat prémoulé laminaire (PLF, 10, 12) incluant ladite première surface de plot pour puce (10A) laissée apparente par le matériau de prémoulage (12) avec la périphérie de l'au moins un plot pour puce (10) limitrophe du matériau de prémoulage (12) moulé sur la structure laminaire (10),
le procédé comprenant la production, à la périphérie de l'au moins un plot pour puce (10), d'au moins une portion incurvée de relaxation des contraintes (100) configurée pour être limitrophe du matériau de prémoulage (12) moulé sur la structure laminaire (10) sur une surface lisse, et
dans lequel la structure laminaire comprend une paire de plots pour puce voisins (10) ayant une bande de matériau de prémoulage (12) entre eux, le procédé comprenant la formation, dans ladite paire de plots pour puce voisins (10), d'une alternance desdites portions incurvées de relaxation des contraintes (100).

2. Procédé selon la revendication 1, dans lequel l'au moins une portion incurvée de relaxation des contraintes (100) s'étend dans le plan du substrat prémoulé laminaire (PLF, 10, 12) le long d'une trajectoire approximativement sinusoïdale.

3. Procédé selon la revendication 1 ou la revendication 2, dans lequel l'au moins une portion incurvée de relaxation des contraintes (100) comprend une saillie rentrant dans le matériau de prémoulage (12) moulé sur la structure laminaire (10).

4. Procédé selon la revendication 3, comprenant la production, dans ladite saillie (100), d'au moins une ouverture (102) configurée pour être remplie du matériau de prémoulage (12) moulé sur la structure laminaire (10).

5. Procédé selon n'importe laquelle des revendications 1 à 4, comprenant la production de ladite au moins une portion incurvée de relaxation des contraintes (100) à un emplacement de ladite structure laminaire (10) où un espace en T est ménagé en vue d'être rempli du matériau de prémoulage (12) moulé sur la structure laminaire (10).

6. Procédé selon la revendication 6, comprenant la formation, dans ladite paire de plots pour puce voisins (10), de saillies incurvées de relaxation des contraintes interdigitées (100), ladite bande de matériau de prémoulage (12) entre eux présentant un motif en serpentin.

7. Procédé selon n'importe laquelle des revendications précédentes, dans lequel l'au moins un plot pour puce (10) présente une seconde surface de plot pour puce (10B) à l'opposé de ladite première surface de plot pour puce (10A), le procédé comprenant la production de l'au moins une portion incurvée de relaxation des contraintes (100) au niveau d'une surface (10A) parmi la première surface de plot pour puce (10A) et la seconde surface de plot pour puce (10B), dans lequel, à l'opposé de ladite au moins une portion incurvée de relaxation des contraintes (100), la périphérie de l'autre surface (10B) parmi la première surface de plot pour puce (10A) et la seconde surface de plot pour puce (10B) est rectiligne.

8. Substrat (PLF), comprenant :
une structure laminaire électriquement conductrice sculptée (10) comportant des espaces en son sein, la structure laminaire incluant au moins un plot pour puce (10) présentant une première surface de plot pour puce (10A) configurée pour avoir au moins une puce de semi-conducteur (C1, C2) montée dessus, et
un matériau de prémoulage (12) moulé sur la structure laminaire (10), le matériau de prémoulage (12) pénétrant dans lesdits espaces et produisant un substrat prémoulé laminaire (PLF, 10, 12) incluant ladite première surface de plot pour puce (10A) laissée apparente par le matériau de prémoulage (12) avec la périphérie de l'au moins un plot pour puce (10) limitrophe du matériau de prémoulage (12) moulé sur la structure laminaire (10), et
au moins une portion incurvée de relaxation des contraintes (100) produite à la périphérie de l'au moins un plot pour puce (10), l'au moins une portion incurvée de relaxation des contraintes (100) étant limitrophe du matériau de prémoulage (12) moulé sur la structure laminaire (10) sur une surface lisse, l'au moins une portion incurvée de relaxation des contraintes (100) s'étendant de préférence dans le plan du substrat prémoulé laminaire (PLF, 10, 12) le long d'une trajectoire approximativement sinusoïdale,
dans lequel la structure laminaire comprend une paire de plots pour puce voisins (10) ayant une bande de matériau de prémoulage (12) entre eux, le substrat comprenant, dans ladite paire de plots pour puce voisins (10), une alternance desdites portions incurvées de relaxation des contraintes (100), de préférence des saillies incurvées de relaxation des contraintes interdigitées (100), ladite bande de matériau de prémoulage (12) entre eux présentant un motif en serpentin.

9. Substrat (PLF) selon la revendication 8, dans lequel l'au moins une portion incurvée de relaxation des contraintes (100) comprend une saillie rentrant dans le matériau de prémoulage (12) moulé sur la structure laminaire (10), la saillie comportant de préférence au moins une ouverture (102) en son sein, l'au moins une ouverture (102) étant remplie du matériau de prémoulage (12) moulé sur la structure laminaire (10).

10. Substrat (PLF) selon la revendication 8 ou la revendication 9, comprenant au moins une portion incurvée de relaxation des contraintes (100) de l'au moins un plot pour puce (10) à un emplacement de ladite structure laminaire (10) où un espace en T est ménagé rempli du matériau de prémoulage (12) moulé sur la structure laminaire (10).

11. Substrat (PLF) selon n'importe laquelle des revendication 8 à 10, dans lequel l'au moins un plot pour puce (10) présente une seconde surface de plot pour puce (10B) à l'opposé de ladite première surface de plot pour puce (10A), dans lequel l'au moins une portion incurvée de relaxation des contraintes (100) est produite au niveau d'une surface (10A) parmi la première surface de plot pour puce (10A) et la seconde surface de plot pour puce (10B), dans lequel, à l'opposé de ladite au moins une portion incurvée de relaxation des contraintes (100), la périphérie de l'autre surface (10B) parmi la première surface de plot pour puce (10A) et la seconde surface de plot pour puce (10B) est rectiligne.

12. Dispositif à semi-conducteur, comprenant :
un substrat (PLF) selon n'importe laquelle des revendications 8 à 11, et
au moins une puce de semi-conducteur (C1, C2) montée sur ladite première surface de plot pour puce (10A) configurée pour avoir au moins une puce de semi-conducteur (C1, C2) montée dessus.
